# EUROPÄISCHE PATENTSCHRIFT

(11) **EP 2 368 154 B1**
(45) Veröffentlichungstag und Bekanntmachung des Hinweises auf die Patenterteilung: **26.02.2014**
(21) Anmeldenummer: 09774839.6
(22) Anmeldetag: 08.12.2009
(51) Int. Cl.: G03F 7/20, H01L 21/683

(54) **WAFER-CHUCK FÜR DIE EUV-LITHOGRAPHIE**
WAFER CHUCK FOR EUV LITHOGRAPHY
MANDRIN POUR PLAQUETTE POUR LITHOGRAPHIE EUV

(30) Priorität: 19.12.2008 DE 102008054982
(43) Veröffentlichungstag der Anmeldung: 28.09.2011
(73) Patentinhaber: Carl Zeiss SMT GmbH, 73447 Oberkochen (DE)
(72) Erfinder: SIX, Stephan, 73431 Aalen (DE)
(74) Vertreter: Kohler Schmid Möbus
(86) Internationale Anmeldenummer: PCT/EP2009/008749
(87) Internationale Veröffentlichungsnummer: WO 2010/069497

(56) Entgegenhaltungen:
- EP-A- 1 406 121
- JP-A- 2006 066 857
- US-A1- 2003 222 416
- US-A1- 2006 222 821

## Beschreibung

### Hintergrund der Erfindung

Die Erfindung betrifft einen Wafer-Chuck mit einem Substrat und mit einer auf dem Substrat aufgebrachten elektrisch leitfähigen Beschichtung zur Fixierung eines Wafers durch elektrostatische Anziehung und bevorzugt mit einer an dem Substrat angebrachten reflektierenden Beschichtung.

Zur Halterung von plattenartigen Objekten in Form von Wafern werden sog. Wafer-Chucks (engl. "chuck" = Spannfutter) eingesetzt, welche den Wafer geeignet positionieren bzw. fixieren. In der EUV-Lithographie befinden sich der Wafer sowie der Wafer-Chuck typischer Weise in einer Vakuum-Umgebung einer EUV-Lithographieanlage. Der Wafer ist hierbei typischer Weise auf einer ebenfalls plattenförmigen Halterung angebracht, die als Wafer-Table bezeichnet wird. Der Wafer wird hierbei zusammen mit dem Wafer-Table durch elektrostatische Anziehung an der Oberseite des Wafer-Chucks fixiert. Die Oberseite des Wafer-Chucks ist zu diesem Zweck mit einer elektrisch leitfähigen Beschichtung versehen, die als Elektrode dient und beispielsweise aus einer Chromschicht bestehen kann. Unter einer elektrisch leitfähigen Beschichtung wird hier eine Beschichtung mit mindestens einer leitfähigen Schicht verstanden, die zur Fixierung des Wafers durch elektrostatische Anziehung elektrisch kontaktierbar ist. Oberhalb oder unterhalb dieser Schicht können ggf. weitere, nicht oder nur schwach leitfähige Schichten angebracht sein. Es versteht sich aber, dass auch die gesamte Beschichtung aus leitfähigen Schichtmaterialien aufgebaut sein kann.

Um die Eigenschaften der Beschichtung im Hinblick auf ihre Kratzfestigkeit weiter zu steigern, wurde die Verwendung von Beschichtungsmaterialien vorgeschlagen, die einen größeren Reibungskoeffizienten und eine höhere Materialhärte als Chrom aufweisen. Diese Materialien werden typischer Weise durch Sputterbeschichtung oder durch ein ionengestütztes Verfahren aufgebracht, was in der Regel zu Schichten führt, die sehr hohe mechanische Druckspannungen von bis zu einigen GPa aufweisen. Unter dem Einfluss dieser hohen mechanischen Schichtspannungen kann es zu einer Deformation des Wafer-Chucks kommen, die im Extremfall dazu führen kann, dass die Anforderungen an die Ebenheit des WaferSubstrats nicht mehr erfüllt sind.

Zwar kann versucht werden, das Auftreten von zu großen Deformationen dadurch zu vermeiden, dass die Beschichtung mit einer möglichst geringen Schichtdicke aufgetragen wird. Hierbei tritt jedoch das Problem auf, dass die aufgebrachte Schicht eine Mindestdicke von ca. 100 nm nicht unterschreiten sollte, um den bei den vorliegenden Anwendungen maximal erlaubten Flächenwiderstand von typischer Weise 100 Ohm bis 200 Ohm nicht zu überschreiten.

Zusätzlich zur elektrisch leitfähigen Beschichtung kann z.B. an den Seitenflächen des Substrats eine reflektierende Beschichtung angebracht sein, die für die exakte Positionierung des Wafer-Chucks z.B. mit Hilfe eines Laserstrahls verwendet werden kann. Auch bei der reflektierenden Beschichtung können zu große Schichtspannungen ggf. zu einer unerwünschten Deformation des Wafer-Chucks führen.

Weiterhin ändern sich Schichtspannungen nach Einbringen ins Vakuum durch eine Verringerung des Wassergehaltes der Schichten. Änderungen der Schichtspannung in der Größenordnung von einigen MPa sind noch über mehrere Tage nach dem Einbringen ins Vakuum hinweg zu beobachten. Eine solche langfristige Schichtspannungsänderung im Vakuum macht ein häufiges Nachkalibrieren der Wafer-Chuck-Positionierung notwendig.

Aus der US 5,936,307 ist es bekannt, zur Spannungsverminderung an einer Titannitrid- bzw. einer Titanschicht eines Wafers ein Substrat aus einem dielektrischen Material aufzurauen, auf dem diese Schicht(en) aufgebracht sind.

Aus der JP 61091354 ist es bekannt, zur Erzeugung einer Beschichtung mit hoher Verschleißfestigkeit eine erste, dünne Schicht eines Materials durch Ionenplattieren auf ein Substrat aufzubringen. Auf die erste Schicht wird eine zweite Schicht aus demselben Material durch Dampfabscheidung aufgebracht, wobei die zweite Schicht eine Zugspannung aufweist. Auf die zweite Schicht wird nachfolgend eine dritte Schicht durch Ionenplattieren in einem reaktiven Gasplasma aufgebracht. Die dritte Schicht kann aus Titannitrid, Bornitrid, Siliziumcarbid etc. bestehen und weist eine Druckspannung auf.

Die US 2008/0153090 A1 beschreibt das Abscheiden einer reflektiven Mehrlagen-Beschichtung auf einem Substrat durch Sputtern. Die durch Sputtern aufgebrachte Mehrlagen-Beschichtung weist eine Schichtspannung auf, die eine Deformation des Substrats zur Folge hat. Um diese Deformation auszugleichen, wird die Mehrlagen-Beschichtung auf ein Substrat aufgebracht, das in der entgegen gesetzten Richtung deformiert ist, so dass sich nach dem Aufbringen der Mehrlagen-Beschichtung die gewünschte, plane Form des Substrats mit der Beschichtung ergibt. Um eine Deformation des Substrats zu erreichen, wird u.a. vorgeschlagen, das Substrat an einem Wafer-Chuck mit gekrümmter Oberfläche zu lagern.

Aus der US 7220319 B2 ist ein Wafer-Chuck mit einem Substrat aus einem leitfähigen Material bekannt geworden, an dem eine Elektrode mit Hilfe von Schrauben fixiert ist. Die Elektrode wird nach oben von einer ersten Schicht begrenzt, deren thermischer Ausdehnungskoeffizient zwischen dem einer dielektrischen Platte, auf welcher der Wafer gelagert ist, und dem Ausdehnungskoeffizienten der Elektrode liegt. Zwischen der Elektrode und dem Substrat ist eine zweite Schicht angeordnet, deren thermischer Ausdehnungskoeffizient ebenfalls zwischen dem der dielektrischen Schicht und dem des Substrats liegt. Durch diese Wahl der thermischen Ausdehnungskoeffizienten soll erreicht werden, dass die Schichtspannung der Elektrode den Schichtspannungen der beiden die Elektrode einschließenden Schichten entgegengesetzt wirkt.

Die JP 2001-223 261 A beschreibt einen elektrostatischen Wafer-Chuck, bei dem zwischen einem elektrisch leitfähigen Substrat und einer isolierenden Deckschicht drei Schichten mit unterschiedlichen thermischen Ausdehnungskoeffizienten aufgebracht sind, um eine graduelle Anpassung zwischen dem Ausdehnungskoeffizienten des Substrats und dem Ausdehnungskoeffizienten der Deckschicht zu erhalten.

Die US 2006/222821 A beschreibt ein mikroelektronisches Dünnschicht-Element 10, bei dem eine elektrisch leitfähige Beschichtung 3 eine unter Druckspannung stehende Schicht 32 sowie eine unter Zugspannung stehende Schicht 31 aufweist.

Eine Anpassung des thermischen Ausdehnungskoeffizienten zwischen einer Elektrode und einer dielektrischen Platte bei einem Wafer-Chuck ist auch aus der US 7,220,319 B2 bekannt. Die Elektrode ist dort zwischen einer Deckschicht und einer Moderationsschicht angeordnet, deren thermische Ausdehnungskoeffizienten jeweils zwischen denen der Elektrode und der dielektrischen Platte liegen.

### Aufgabe der Erfindung

Aufgabe der Erfindung ist es, einen Wafer-Chuck mit einer bevorzugt auch nach Einbringen des Wafer-Chucks ins Vakuum deformationsarmen Beschichtung zu versehen.

### Gegenstand der Erfindung

Diese Aufgabe wird gelöst durch einen Wafer-Chuck der eingangs genannten Art, bei dem die Beschichtung mindestens eine erste, unter Druckspannung stehende Schicht sowie mindestens eine zweite, unter Zugspannung stehende Schicht zur Kompensation der Druckspannung der ersten Schicht aufweist.

Erfindungsgemäß wird vorgeschlagen, die Druckspannung der ersten Schicht, die z.B. durch Sputtern aufgetragen wird, durch mindestens eine weitere Schicht möglichst vollständig zu kompensieren, die eine Zugspannung aufweist. Das Material der zweiten Schicht, ihre Dicke sowie die Art der Auftragung werden hierbei so gewählt, dass die das Substrat deformierende Wirkung der Zugspannung der zweiten Schicht durch die entgegen gesetzte Wirkung der Druckspannung der ersten Schicht weitestgehend ausgeglichen wird. Auf diese Weise kann ein Wafer-Chuck mit einer insgesamt deformationsfreien Beschichtung erhalten werden, wodurch eine Deformation des Substrats des Wafer-Chucks, auf dem die Beschichtung aufgebracht ist, verhindert werden kann. Dieses Vorgehen lässt sich sowohl bei der elektrisch leitfähigen Beschichtung als auch bei der reflektierenden Beschichtung anwenden, wobei bei letzterer in Einzelfällen, z.B. wenn die Gesamtdicke der Beschichtung sehr gering ist, ggf. auch auf eine solche Kompensation verzichtet werden kann.

In einer Ausführungsform ist das Material der ersten Schicht ausgewählt aus der Gruppe umfassend: Nitride, Carbide und Silizide. Materialien aus diesen Stoffgruppen weisen in der Regel eine große Härte und daher eine hohe Kratzfestigkeit auf, was für die vorliegenden Anwendungen besonders günstig ist.

In einer weiteren Ausführungsform ist das Material der ersten Schicht der elektrisch leitfähigen Beschichtung ausgewählt aus der Gruppe umfassend: Titannitrid (TiN), Chromnitrid (CrN), Molybdänsilizid (MoSi₂), Siliziumcarbid (SiC) und Siliziumnitrid (Si₃N₄). Insbesondere Titannitrid und Chromnitrid haben sich aufgrund ihrer Festigkeitseigenschaften als besonders geeignete Schichtmaterialien für die Deckschicht der Beschichtung erwiesen.

In einer weiteren Ausführungsform weist die zweite Schicht der elektrisch leitfähigen Beschichtung eine Zugspannung zwischen 100 MPa und 1600 MPa, bevorzugt zwischen 800 MPa und 1300 MPa auf. Wie oben ausgeführt ist es zur Kompensation der hohen Druckspannungen, wie sie typischer Weise beim Sputtern der ersten Schicht erzeugt werden, erforderlich, mit Hilfe der zweiten Schicht eine erhebliche Zugspannung zu erzeugen. Die zweite Schicht kann hierbei aus einem Metall, insbesondere aus Chrom bestehen, das durch thermisches Verdampfen auf das Substrat aufgebracht wird, wobei Zugspannungen von typsicher Weise zwischen 800 MPa und 1300 MPa erreicht werden. Chrom als Schichtmaterial hat hierbei den Vorteil, dass beispielsweise bereits eine geringe Schichtdicke zwischen 40 nm und 80 nm ausreicht, um die Substratdeformation einer 50nm bis 100nm dicken Deckschicht mit 1 GPa Druckspannung auszugleichen. Es versteht sich jedoch, dass auch andere Schichtmaterialien für die zweite Schicht verwendet werden können, die geeignet sind, eine ausreichende Zugspannung zu erzeugen. Beispiele für solche Materialien sind metallisches Titan, Zirkon oder Hafnium.

Die Erfinder haben herausgefunden, dass es günstig ist, wenn die zweite Schicht der elektrisch leitfähigen Beschichtung aus einem Material mit höherer elektrischer Leitfähigkeit als dem Material der ersten Schicht gebildet ist. In diesem Fall kann der maximal erlaubte Flächenwiderstand der als Elektrode dienenden leitfähigen Beschichtung eingehalten werden, ohne dass die erste Schicht mit zu großer Dicke aufgebracht werden muss. Dies ist insbesondere für den Fall günstig, dass die erste Schicht aufgrund einer zu hohen Linienspannung bei zu dickem Auftragen Risse bildet oder sich vom Substrat bzw. von der zweiten Schicht ablöst. Der Flächenwiderstand kann auch gegenüber einer alleinstehenden ersten Schicht vermindert werden, wenn die zweite Schicht von geringerer elektrischer Leitfähigkeit ist als die erste Schicht, wenn sich hierbei die Gesamtdicke des elektrisch leitfähigen Schichtpaketes erhöht.

In einer weiteren Ausführungsform weist die erste Schicht der elektrisch leitfähigen Beschichtung eine Dicke von weniger als 200 nm, bevorzugt von weniger als 100 nm, insbesondere von weniger als 50 nm auf. Wie oben dargestellt kann insbesondere bei Verwendung einer zweiten Schicht mit einer elektrischen Leitfähigkeit, die größer ist als diejenige der ersten Schicht, die Dicke der ersten Schicht geringer gewählt werden als dies bei Verwendung einer einzigen leitfähigen Schicht möglich wäre.

In der Regel besteht das Substrat aus einem nicht leitfähigen Material, insbesondere aus Zerodur. Hierbei ist das Schichtmaterial der zweiten Schicht so gewählt, dass es möglichst gute Hafteigenschaften auf dem nicht leitfähigen Material bzw. auf Zerodur aufweist. In der Regel ist dies der Fall, wenn die zweite Schicht eine hohe chemische Bindungsaffinität zum Substrat-Material aufweist. Es versteht sich, dass das Material der zweiten Schicht auch so gewählt werden kann, dass die zweite Schicht als Haftvermittlerschicht für die erste Schicht dient. Dies ist insbesondere dann gewährleistet, wenn die erste Schicht aus einem Nitrid, Carbid oder Silizid eines Materials besteht, das auch in der zweiten Schicht enthalten ist, z.B. wenn als Material der zweiten Schicht Chrom und als Material der ersten Schicht Chromnitrid gewählt wird.

In einer Ausführung ist die erste Schicht auf die zweite Schicht aufgebracht, d.h. die erste, eine Druckspannung aufweisende Schicht ist über der zweiten, eine Zugspannung aufweisenden Schicht angeordnet. Die erste Schicht ist hierbei typischer Weise die Deckschicht der Beschichtung und wird mit dem Wafer bzw. der Wafer-Table in Kontakt gebracht, während die zweite Schicht zur Kompensation der Schichtspannung der ersten Schicht dient.

In einer weiteren Ausführungsform ist die erste Schicht der elektrisch leitfähigen Beschichtung durch Sputtern, insbesondere mit Ionenstützung, und die zweite Schicht durch thermisches Verdampfen gebildet. Typischer Weise wird durch Sputtern eines Materials eine Druckspannung in der hierbei erzeugten Materialschicht erzeugt, während beim thermischen Verdampfen eine Zugspannung entsteht, wobei der Grad der Druck- bzw. Zugspannung auch von der Art des aufgebrachten Materials sowie den Prozessparametern Aufdampfrate, Gasdruck und Gaszusammensetzung während des Aufdampfprozesses und des gewählten Sputterverfahrens abhängt. Die Ionenstützung der aufwachsenden Schicht dient zur Erhöhung der Schichthärte und zur gezielten Beeinflussung der Schichtrauhigkeit und damit des Reibungskoeffizienten der Schichtoberfläche.

Es hat sich gezeigt, dass die Schichtspannungen sowohl der elektrisch leitfähigen Beschichtung als auch der reflektierenden Beschichtung sich beim Betrieb des Wafer-Chucks unter Vakuum-Bedingungen durch das Entweichen von Wasser verändern kann, das sich zuvor bei der Lagerung des Wafer-Chucks an Luft in die Schichtstruktur eingelagert hat. Da das Entweichen von Wasser aus den Beschichtungen unter Vakuumbedingungen nur verhältnismäßig langsam erfolgt, verändert sich die Schichtspannung und damit die Oberflächenebenheit des Wafer-Chucks ebenfalls nur relativ langsam. Die Zeitdauer, bis es zu einer ausreichenden Stabilisierung der Schichtspannung kommt, kann im Bereich von mehreren Tagen liegen. Will man den Wafer-Chuck nach der Belüftung einer Vakuum-Umgebung z.B. in einem EUV-Lithographiesystem wieder in Betrieb nehmen, muss man daher entweder abwarten, bis sich die Schichtspannung stabilisiert hat, oder eine Verschlechterung des Overlays bei mehreren aufeinander folgenden Belichtungsschritten in Kauf nehmen.

Bei einer Ausführungsform ist die elektrisch leitfähige und/oder reflektierende Beschichtung aus metallischen Schichtmaterialien und/oder aus dielektrischen, mit Ionenstützung abgeschiedenen Schichtmaterialien gebildet. Der Erfinder hat erkannt, dass die Änderung der mechanischen Schichtspannungen von Schichtmaterialien im Vakuum verringert werden kann, wenn diese nur wenig oder kein Wasser in ihre Schichtstruktur einbauen. Ein geeignetes metallisches Schichtmaterial für die elektrisch leitfähige Beschichtung stellt das oben erwähnte Chrom dar. Bei der reflektierenden Beschichtung haben sich Aluminium und Silber als besonders geeignete Schichtmaterialien erwiesen, die z.B. als unterste Spiegel-Schicht der reflektierenden Beschichtung verwendet werden können.

Neben metallischen Schichtmaterialien können auch z.B. dielektrische Schichtmaterialien mit geringer Porosität verwendet werden, da sich in wenig porösen Schichten nur eine kleine Menge Wasser einlagern kann. Als besonders geeignet haben sich dielektrische Schichten erwiesen, die mit lonenunterstützung ("ion assisted deposition") aufgebracht werden, z.B. unter Verwendung einer "Advanced Plasma Source" (APS) als Ionenstrahlquelle. Beispiele für im Vakuum mechanisch spannungsstabile Schichtmaterialien bei einer elektrisch leitfähigen Beschichtung sind insbesondere Titannitrid (TiN) und Chromnitrid (CrN), die bevorzugt unter Stickstoff-Ionenbeschuss aufgedampft werden. Als in einer Vakuum-Umgebung spannungsstabile Schichtmaterialien für die reflektierende Beschichtung kommen insbesondere Materialien in Frage, die ausgewählt sind aus der Gruppe: Titandioxid (TiO₂), Siliziumdioxid (SiO₂), Hafniumdioxid (HfO₂) und Zirkondioxid (ZrO₂). Diese oxidischen Materialien werden bevorzugt unter Ionenbeschuss hergestellt, wobei sich insbesondere die Verwendung von Argon- oder Sauerstoffionen als besonders vorteilhaft herausgestellt hat.

Bei einer Ausführungsform des Wafer-Chucks weist die elektrisch leitende und/oder die reflektierende Beschichtung eine wasserundurchlässige Versiegelungsschicht als Abschlussschicht auf. Die Verwendung einer solchen Versiegelungsschicht stellt eine weitere Möglichkeit dar, die Änderung des Wassergehalts und damit die Änderung der mechanischen Schichtspannung von insbesondere dielektrischen Schichten im Vakuum zu verringern.

Die Dicke der Versiegelungsschicht kann dabei so gewählt werden, dass sie die Reflexion der Beschichtung direkt verstärkt. In diesem Fall liegt die optische Schichtdicke typischer Weise bei einem Viertel der Arbeitswellenlänge, für welche die reflektierende Beschichtung ausgelegt ist. Die Arbeitswellenlänge entspricht hierbei typischer Weise der Wellenlänge des zur Positionierung verwendeten Laserstrahls und kann z.B. bei 633 nm liegen. Die Versiegelungsschicht kann aber auch optisch inaktiv sein, d.h. die Reflexion der Beschichtung wird durch die Versiegelungsschicht zumindest nicht verschlechtert. Letzteres lässt sich entweder durch eine sehr geringe Schichtdicke von wenigen Nanometern oder eine optische Schichtdicke von einem ganzzahligen Vielfachen der halben Arbeitswellenlänge erreichen. Beispiele für eine solche Versiegelungsschicht sind dünne, organische Schichten (z.B. aus Optron, Teflon AF) und hydrophobe Schichten, die z.B. mit einem CVD-Prozess erzeugt werden können. Ebenfalls eine versiegelnde Wirkung können mit Ionenstrahlstützung oder einem Sputterverfahren (z.B. Magnetron-Sputtering, Ion Beam Sputtering) hergestellte Abschlussschichten z.B. aus Siliziumdioxid haben.

Bei einer weiteren Ausführungsform weist die elektrisch leitfähige Beschichtung eine Gesamtdicke von weniger als 300 nm und die reflektierende Beschichtung eine Gesamtdicke von weniger als 400 nm auf. Eine geringe Gesamtdicke der Beschichtung ist günstig, da die Änderung der Verformung des Substrates von der Linienspannung, d.h. dem Produkt aus Schichtspannung und Schichtdicke, abhängt. Somit lässt sich die Änderung der Verformung eines Wafer-Chucks für EUV-Anwendungen nach dem Einbringen ins Vakuum auch dadurch verringern, dass die Schichtdicke der elektrisch leitfähigen Beschichtung und/oder der reflektierenden Beschichtung möglichst klein gehalten wird. Dies bedeutet für die elektrisch leitfähige Beschichtung, dass Schichtmaterialien mit möglichst hoher elektrischer Leitfähigkeit gewählt werden sollten (z.B. Titannitrid an Stelle von Chromnitrid). Um bei der reflektierenden Beschichtung eine möglichst geringe Gesamtdicke bei hoher Reflexion zu erzielen, sollten die verwendeten Schichtmaterialien einen möglichst großen Brechungsindexunterschied bei der Arbeitswellenlänge aufweisen. Bei einer Arbeitswellenlänge von z.B. 633 nm kann an Stelle von Hafniumdioxid z.B. Titandioxid als hochbrechendes Schichtmaterial verwendet werden, da dieses einen höheren Brechungsindex als Hafniumdioxid aufweist.

Zusätzlich oder alternativ zum oben beschriebenen Vorgehen kann die zweite, unter Zugspannung stehende Schicht ausgebildet sein, eine durch Wasserverlust in einer Vakuumumgebung hervorgerufene Spannungsänderung der ersten, unter Druckspannung stehenden Schicht im Wesentlichen zu kompensieren. In diesem Fall wird eine Beschichtung verwendet, deren einzelne Schichten bei Wasserverlust unterschiedliche Spannungsänderungen aufweisen. Die Gesamtspannung der Beschichtung ändert sich bei Wasserverlust z.B. weniger, wenn es sowohl Schichten gibt, die durch Wasserverlust ihre Schichtspannung erhöhen als auch solche, die durch Wasserverlust ihre Schichtspannung vermindern. Ebenfalls eine abgeschwächte Änderung der Gesamtspannung einer Beschichtung erhält man, wenn ein Teil der Schichten durch Wasserverlust ihre Zugspannung erhöhen bzw. vermindern, während andere Schichten ihre Druckspannung im gleichen Maße erhöhen bzw. vermindern. Typischer Weise wird durch den Wasserverlust bei den hier beschriebenen Materialien entweder eine Druckspannung verringert oder eine Zugspannung erhöht, jedoch kann bei geeigneter Wahl der Schichtmorphologie und -chemie in die Schichtstruktur eingelagertes Wasser beispielsweise auch eine Zugspannung bewirken, die sich bei Wasserverlust verringert.

Weitere Merkmale und Vorteile der Erfindung ergeben sich aus der nachfolgenden Beschreibung von Ausführungsbeispielen der Erfindung, anhand der Figuren der Zeichnung, die erfindungswesentliche Einzelheiten zeigen, und aus den Ansprüchen. Die einzelnen Merkmale können je einzeln für sich oder zu mehreren in beliebiger Kombination bei einer Variante der Erfindung verwirklicht sein.

### Zeichnung

Ausführungsbeispiele sind in der schematischen Zeichnung dargestellt und werden in der nachfolgenden Beschreibung erläutert. Es zeigt:
- **Fig. 1**: eine schematische Darstellung eines Wafer-Chucks mit einer elektrisch leitfähigen Beschichtung mit einer einzigen, unter Druckspannung stehenden Schicht,
- **Fig. 2**: eine schematische Darstellung einer Ausführungsform eines erfindungsgemäßen Wafer-Chucks, bei der unter der ersten Schicht eine zweite, unter Zugspannung stehende Schicht angebracht ist,
- **Fig. 3**: eine schematische Darstellung eines Wafer-Chucks mit einer elektrisch leitfähigen Beschichtung und einer reflektierenden Beschichtung in einer Vakuum-Umgebung, sowie
- **Fig. 4**: eine schematische Darstellung einer Ausführungsform eines erfindungsgemäßen Wafer-Chucks mit Mitteln zur Verhinderung einer durch Wasserverlust in der Vakuum-Umgebung hervorgerufenen Spannungsänderung in den Beschichtungen.

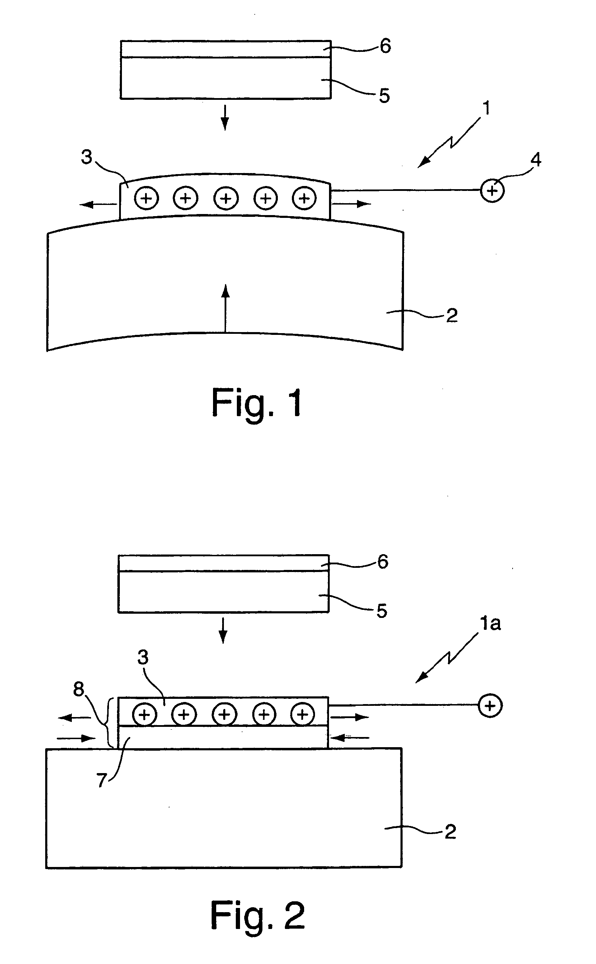

In **Fig. 1** ist schematisch ein Wafer-Chuck **1** für die EUV-Lithographie gezeigt, der ein Substrat **2** aus Zerodur aufweist, auf dem eine Beschichtung mit einer einzigen, ersten Schicht **3** aufgebracht ist, die aus einem elektrisch leitfähigen, kratzfesten Material besteht. Als Schichtmaterialien für die erste Schicht 3 bieten sich Nitride, insbesondere Titannitrid (TiN), Siliziumnitrid (Si₃N₄) oder Chromnitrid (CrN), aber auch Carbide, z.B. Siliziumcarbid (SiC) und ggf. auch Silizide, z.B. Molybdänsilizid (MoSi₂) an.

Die elektrisch leitfähige Schicht 3 dient als Elektrode und steht mit einer Spannungsquelle **4** in Verbindung, um die Schicht 3 auf ein positives Potential zu halten. Auf diese Weise kann ein auf einer Wafer-Table **5** aus einem dielektrischen Material bzw. einer Glaskeramik wie Zerodur oder Korderit gelagerter Wafer **6** durch elektrostatische Anziehung auf dem Wafer-Chuck 1 fixiert werden. Die Fixierung des Wafers 6 durch elektrostatische Anziehung ist beim Einsatz des Wafer-Chucks 1 in der EUV-Lithographie die Regel, da die dort eingesetzten EUV-Lithograpiesysteme unter Vakuum-Bedingungen betrieben werden, so dass eine Fixierung des Wafers 6 durch Vakuum-Ansaugen in der Regel nicht möglich ist.

Die Schicht 3 ist durch ein Sputterverfahren aufgebracht, was dazu führt, dass die Schicht 3 eine hohe mechanische Druckspannung aufweist, die ggf. bei 1 GPa oder darüber liegt. Eine solche Druckspannung kann zu einer Deformation der Schicht 3 sowie des Substrats 2 führen, die so groß ist, dass die Anforderungen an die Ebenheit des Substrats 2 nicht mehr erfüllt sind, wie in stark überhöhter Darstellung in Fig. 1 gezeigt ist.

Wie in **Fig. 2** anhand eines weiteren Wafer-Chucks **1a** gezeigt ist, kann eine solche Deformation wirksam verhindert werden, indem zwischen das Substrat 2 und die erste Schicht 3 mit der mechanischen Druckspannung eine zweite Schicht **7** eingebracht wird, welche eine mechanische Zugspannung aufweist. Die Schichtdicke und das Material der zweiten Schicht 7 werden hierbei im Idealfall so gewählt, dass deren Zugspannung die Druckspannung der ersten Schicht 3 gerade kompensiert, so dass die Beschichtung 3,7 insgesamt spannungsfrei ist und das Substrat 2 durch die Beschichtung 3,7 nicht deformiert wird.

Als Schichtmaterialien für die zweite Schicht sind metallische Materialien, insbesondere Chrom geeignet, da dieses eine hohe elektrische Leitfähigkeit und bei geeigneter Auftragung eine hohe Zugspannung aufweist. Wird Chrom z.B. durch thermisches Verdampfen auf dem Substrat 2 abgeschieden, ist die Dicke der Chromschicht so zu wählen, dass das Produkt aus Schichtdicke und Schichtspannung, die bei Chrom je nach Oxidationsgrad zwischen 800 MPa und 1300 MPa liegt, das Produkt von Schichtspannung und -dicke der ersten Schicht möglichst gut kompensiert.

Es versteht sich, dass neben Chrom auch andere Materialien für die zweite Schicht 7 verwendet werden können, insbesondere solche, die eine hohe Zugspannung von typischer Weise zwischen 100 MPa und 1600 MPa aufweisen und die gute Hafteigenschaften sowohl bezüglich des Materials des Substrats 2, z.B. Zerodur, als auch bezüglich des Materials der ersten Schicht 3 aufweisen, so dass die zweite Schicht 7 als Haftvermittlerschicht zwischen der ersten Schicht 3 und dem Substrat 2 dienen kann.

Das Aufbringen einer zweiten Schicht 7 aus einem Material wie Chrom, das eine höhere elektrische Leitfähigkeit als das Material der ersten Schicht 3 aufweist, die z.B. aus Chromnitrid besteht, ist günstig, da in diesem Fall die Dicke der ersten Schicht 3 verringert werden kann und dennoch der erforderliche niedrige Flächenwiderstand der Beschichtung 3, 7 von maximal ca. 100 bis 200 Ohm nicht überschritten wird. Dies ist insbesondere in dem Fall günstig, dass das Material der ersten Schicht 3, z.B. Titannitrid oder Chromnitrid, auf Grund einer zu hohen Linienspannung bei zu großer Dicke (typischer Weise mehr als ca. 200 nm) Risse bildet oder sich vom Substrat 2 ablöst.

Es versteht sich, dass anders als oben beschrieben die elektrisch leitfähige Beschichtung auch mehr als zwei Schichten aufweisen kann, deren Schichtspannungen so gewählt werden, dass sich in der Beschichtung insgesamt Zug- und Druckspannungen gerade kompensieren.

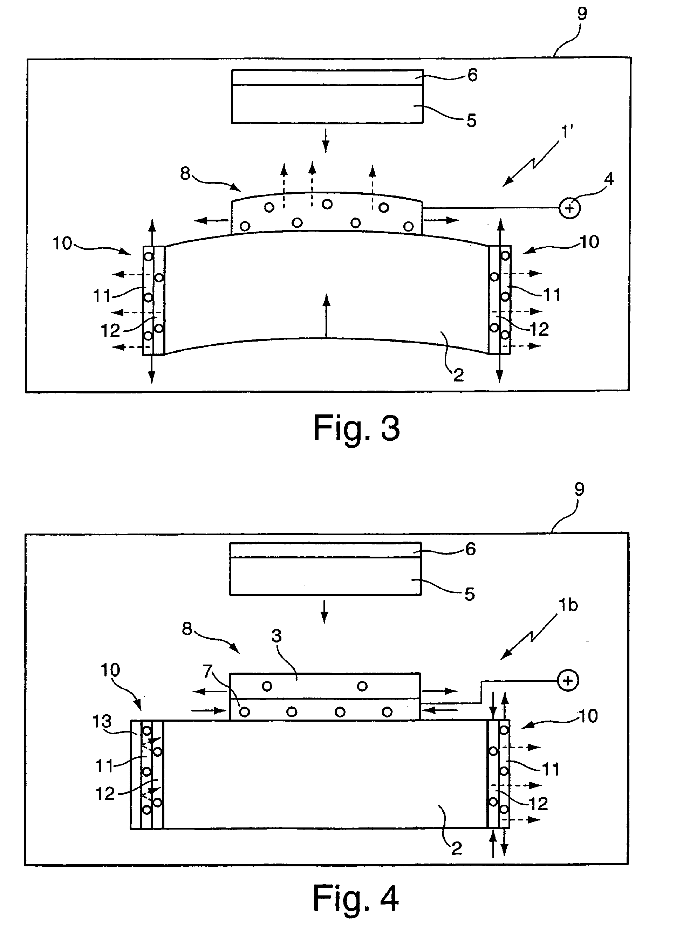

Die Verwendung von mehr als zwei Schichten ist insbesondere typisch für eine reflektierende Beschichtung **10,** wie sie an den Seitenflächen des Substrats 2 eines in **Fig. 3** gezeigten Wafer-Chucks **1'** gebildet ist. Die reflektierende Beschichtung 10 dient hierbei der präzisen Positionierung des Wafer-Chucks 1' mittels eines auf die Beschichtung 10 ausgerichteten und von dort reflektierten Laserstrahls (nicht gezeigt). In Fig. 3 ist beispielhaft die reflektierende Beschichtung 10 mit lediglich einer ersten Schicht **11** und einer zweiten Schicht **12** gezeigt. Es versteht sich aber, dass die reflektierende Beschichtung 10 auch eine Mehrzahl von Schichten, typischer Weise mit abwechselnd hohem und niedrigem Brechungsindex aufweisen kann. Die Schichtmaterialien und Schichtdicken der Schichten 11, 12 sind hierbei so gewählt, dass eine ggf. vorhandene Druckspannung der ersten Schicht 11 von einer Zugspannung der zweiten Schicht 12 im Wesentlichen kompensiert wird, was z.B. bei Verwendung von Siliziumdioxid und Titandioxid als Schichtmaterialien besonders einfach möglich ist. Es versteht sich, dass Schichtmaterialien und Schichtdicken der Schichten 11, 12 so gewählt werden sollten, dass diese die optischen Anforderungen insbesondere im Hinblick auf die Reflektivität erfüllen, wobei zusätzlich eine Spannungskompensation der Schichten 11, 12 realisiert werden sollte. Es versteht sich, dass bei der reflektierenden Beschichtung 10, insbesondere wenn diese eine geringe Schichtdicke aufweist, gegebenenfalls auch auf die Spannungskompensation verzichtet werden kann. Auch in diesem Fall sollte aber eine Veränderung der Schichtspannung der reflektierenden Beschichtung 10 beim Einbringen des Wafer-Chucks 1' ins Vakuum vermieden werden, wie weiter unten näher ausgeführt ist.

Obwohl bei dem in Fig. 3 dargestellten Wafer-Chuck 1' sich sowohl an der elektrisch leitenden Beschichtung 8 als auch an der reflektierenden Beschichtung 10 die Zug- und Druckspannungen im Wesentlichen kompensieren, tritt, wie in Fig. 3 gezeigt, dennoch eine Deformation des Wafer-Chucks 1' in einer Vakuum-Kammer/Umgebung **9** auf, die im vorliegenden Fall z.B. durch ein evakuiertes Gehäuseteil einer EUV-Lithographieanlage gebildet sein kann.

Eine solche Deformation kommt dadurch zu Stande, dass die Schichtspannungen sowohl der elektrisch leitfähigen Beschichtung als auch der reflektierenden Beschichtung sich beim Betrieb des Wafer-Chucks unter Vakuum-Bedingungen durch das Entweichen von Wasser (in Fig. 3 durch Kreise veranschaulicht) verändern, das sich zuvor in die Schichten 7, 8 bzw. 11, 12 der Beschichtungen 8, 10 eingelagert hat. Da das Entweichen von Wasser (vgl. gestrichelte Pfeile) aus den Beschichtungen 8, 10 unter Vakuumbedingungen nur verhältnismäßig langsam erfolgt, verändert sich die Deformation des Wafer-Chucks 1' zeitabhängig, bis sich ein stationärer Zustand einstellt, der ggf. erst nach mehreren Tagen erreicht wird.

Um einen Wafer-Chuck möglichst rasch unter Vakuum-Bedingungen einsetzen zu können, ist es erforderlich, an diesem Mittel vorzusehen, die einen Wasserverlust der Beschichtungen 8, 10 in der Vakuum-Kammer 9 wirksam verhindern bzw. zumindest verringern. Mehrere Möglichkeiten hierzu sind beispielhaft in Verbindung mit einem Wafer-Chuck **1b** beschrieben, der in **Fig. 4** dargestellt ist.

Bei der elektrisch leitenden Beschichtung 8 kann eine Deformation z.B. dadurch verhindert werden, dass Schichtmaterialien verwendet werden, die nur wenig Wasser einlagern. Als Schichtmaterialien für die erste Schicht 3 bieten sich hierbei insbesondere Titannitrid (TiN) oder Chromnitrid (CrN) an, die z.B. unter Stickstoffionen-Beschuss aufgedampft werden und dadurch nur eine geringe Porosität aufweisen. Als zweite Schicht 7 kann eine Metallschicht, z.B. eine Chromschicht, verwendet werden, da Metalle in der Regel nur geringe Mengen Wasser einlagern.

Bei der auf der linken Seite von Fig. 4 dargestellten reflektierenden Beschichtung 10 ist auf die Schichten 11, 12 eine wasserundurchlässige Versiegelungsschicht 13 als Abschlussschicht aufgebracht, die den Durchtritt von Wasser verhindert. Als Versiegelungsschicht 13 können z.B. dünne, organische Schichten (Optron, Teflon AF) und hydrophobe Schichten, die z.B. mit einem CVD-Prozess erzeugt werden, zum Einsatz kommen. Ebenfalls eine versiegelnde Wirkung können mit Ionenstrahlstützung oder einem Sputterverfahren (Magnetron-Sputtering, Ion Beam Sputtering) hergestellte AbschlussSchichten z.B. aus Siliziumdioxid erzeugen. Die Dicke der Versiegelungsschicht 13 kann hierbei so gewählt werden, dass diese zur Reflexion der Beschichtung 10 beiträgt (z.B. bei der Wahl einer Schichtdicke, die ein Viertel der Arbeitswellenlänge beträgt) oder optisch inaktiv ist (z.B. bei der Wahl einer besonders kleinen Schichtdicke oder bei einer Schichtdicke mit einem ganzzahligen Vielfachen der halben Arbeitswellenlänge).

Bei der auf der rechten Seite von Fig. 4 gezeigten reflektierenden Beschichtung 10 wird eine Deformation des Substrats 2 dadurch verhindert, dass die zweite Schicht 12 ausgebildet ist, eine durch den Wasserverlust hervorgerufene Spannungsänderung der ersten Schicht 11 zu kompensieren. Dies kann erreicht werden, wenn die Schichten 11, 12 sich in ihrem Spannungsverhalten voneinander unterscheiden, d.h. wenn sich beispielsweise bei Wasserverlust die Druckspannung der ersten Schicht 11 verringert und sich in gleichem Maße auch die Zugspannung der zweiten Schicht 12 verringert.

Es versteht sich, dass auch bei der reflektierenden Beschichtung 10 Änderungen der Schichtspannung kompensiert werden können, indem Schichtmaterialien gewählt werden, die nur geringe Mengen Wasser einlagern können. Dies ist z.B. bei metallischen Schichtmaterialien wie Aluminium (Al) oder Silber (Ag) der Fall, die als unterste Schicht (Spiegelfläche) der reflektierenden Beschichtung 10 verwendet werden können.

Auf diese verspiegelte Fläche können eine oder mehrere Schichten eines bevorzugt typischer Weise oxidischen Schichtmaterials zur Reflexionsverstärkung aufgebracht werden, beispielsweise Titandioxid (TiO₂), Siliziumdioxid (SiO₂), Hafniumdioxid (HfO₂) oder Zirkondioxid (ZrO₂). Erfolgt die Abscheidung dieser dielektrischen Materialien mit Ionenunterstützung, insbesondere unter Verwendung von Sauerstoff- oder Argon-Ionen, kann die Porosität dieser Schichten so weit reduziert werden, dass sich nur geringe Mengen Wasser in deren Schichtstruktur einlagern können.

Zusätzlich oder alternativ kann die Änderung der Verformung des Substrats 2 in der Vakuum-Kammer 9 auch dadurch reduziert werden, dass die Gesamtdicke der Beschichtung 8, 10 möglichst gering gewählt wird, da diese von der Linienspannung, d.h. dem Produkt aus Schichtspannung und Schichtdicke, abhängt. Dies kann z.B. bei der elektrisch leitenden Beschichtung 8 dadurch erreicht werden, dass zusätzlich zur Verwendung von Chrom als Schichtmaterial für die zweite Schicht 7 auch für die erste Schicht 3 ein Schichtmaterial mit hoher elektrischer Leitfähigkeit, z.B. Titannitrid, gewählt wird, so dass die elektrisch leitfähige Beschichtung 8 mit einer Gesamtdicke von weniger als 300 nm hergestellt werden kann.

Auch bei der reflektierenden Beschichtung 10 kann die Gesamtdicke reduziert werden, indem Schichtmaterialien gewählt werden, die einen möglichst großen Unterschied im Brechungsindex aufweisen, z.B. wenn bei einer Arbeitswellenlänge des zur Positionierung verwendeten Laserstrahls von 633 nm Titandioxid (Brechungsindex n von ca. 2.2-2.3) an Stelle von Hafniumdioxid (Brechungsindex n von ca. 1.9-2.0) verwendet wird. Auf diese Weise kann eine reflektierende Beschichtung 10 mit einer Gesamtdicke von weniger als 400 nm erhalten werden.

In jedem Fall kann auf die oben beschriebene Weise ein Wafer-Chuck mit einer elektrisch leitfähigen Beschichtung erhalten werden, die eine hohe Kratzfestigkeit, eine gute elektrische Leitfähigkeit sowie vernachlässigbar kleine Spannungen aufweist. Ebenso kann auf die oben beschriebene Weise eine reflektierende Beschichtung mit nur geringen Spannungen erhalten werden. Insbesondere können auf die oben vorgeschlagene Weise Schichtspannungsänderungen der beiden Beschichtungen durch den Austritt von Wasser in einer Vakuum-Umgebung kompensiert bzw. vermieden werden.

## Patentansprüche

1. Wafer-Chuck (1 a, 1 b) mit einem Substrat (2) und mit einer auf dem Substrat (2) aufgebrachten elektrisch leitfähigen Beschichtung (8) zur Fixierung eines Wafers (6) durch elektrostatische Anziehung und bevorzugt mit einer an dem Substrat (2) angebrachten reflektierenden Beschichtung (10),
**dadurch gekennzeichnet**
**dass** die Beschichtung (8; 10) mindestens eine erste, unter Druckspannung stehende Schicht (3; 11), sowie mindestens eine zweite, unter Zugspannung stehende Schicht (7; 12) zur Kompensation der Druckspannung der ersten Schicht (3; 11) aufweist.

2. Wafer-Chuck nach Anspruch 1, bei dem das Material der ersten Schicht (3) der elektrisch leitfähigen Beschichtung (8) ausgewählt ist aus der Gruppe umfassend: Nitride, Carbide und Silizide.

3. Wafer-Chuck nach Anspruch 1 oder 2, bei dem das Material der ersten Schicht (3) der elektrisch leitfähigen Beschichtung (8) ausgewählt ist aus der Gruppe umfassend: Titannitrid (TiN), Chromnitrid (CrN), Molybdänsilizid (MoSi₂), Siliziumcarbid (SiC) und Siliziumnitrid (Si₃N₄).

4. Wafer-Chuck nach einem der vorhergehenden Ansprüche, bei dem die zweite Schicht (7) der elektrisch leitfähigen Beschichtung (8) eine Zugspannung zwischen 100 MPa und 1600 MPa, bevorzugt zwischen 800 MPa und 1300 MPa aufweist.

5. Wafer-Chuck nach einem der vorhergehenden Ansprüche, bei dem die zweite Schicht (7) der elektrisch leitfähigen Beschichtung (8) aus einem Metall, bevorzugt aus Chrom besteht.

6. Wafer-Chuck nach einem der vorhergehenden Ansprüche, bei dem die zweite Schicht (7) der elektrisch leitfähigen Beschichtung (8) aus einem Material mit höherer elektrischer Leitfähigkeit als dem Material der ersten Schicht (3) gebildet ist.

7. Wafer-Chuck nach einem der vorhergehenden Ansprüche, bei dem die erste Schicht (3) der elektrisch leitfähigen Beschichtung (8) eine Dicke von weniger als 200 nm, bevorzugt von weniger als 100 nm, insbesondere von weniger als 50 nm aufweist.

8. Wafer-Chuck nach einem der vorhergehenden Ansprüche, bei dem das Substrat (2) aus einem nicht leitfähigen Material, insbesondere aus Zerodur besteht.

9. Wafer-Chuck nach einem der vorhergehenden Ansprüche, bei dem die erste Schicht (3; 11) auf die zweite Schicht (7; 12) aufgebracht ist.

10. Wafer-Chuck nach einem der vorhergehenden Ansprüche, bei dem die erste Schicht (3) der elektrisch leitfähigen Beschichtung (8) durch Sputtern, insbesondere mit Ionenstützung, und die zweite Schicht (7) durch thermisches Verdampfen gebildet ist.

11. Wafer-Chuck nach einem der vorhergehenden Ansprüche, bei dem die Beschichtung (8; 10) aus metallischen Schichtmaterialien und/oder aus dielektrischen, mit Ionenstützung abgeschiedenen Schichtmaterialien gebildet ist.

12. Wafer-Chuck nach einem der vorhergehenden Ansprüche, bei dem die reflektierende Beschichtung (10) mindestens ein metallisches Schichtmaterial, insbesondere Aluminium (Al) oder Silber (Ag) aufweist.

13. Wafer-Chuck nach einem der vorhergehenden Ansprüche, bei dem die reflektierende Beschichtung (10) mindestens ein bevorzugt mit Ionenstützung abgeschiedenes Schichtmaterial aufweist, das ausgewählt ist aus der Gruppe umfassend: Titandioxid (TiO₂), Siliziumdioxid (SiO₂), Hafniumdioxid (HfO₂) und Zirkondioxid (ZrO₂).

14. Wafer-Chuck nach einem der vorhergehenden Ansprüche, bei dem die Beschichtung (8; 10) eine wasserundurchlässige Versiegelungsschicht (13) aufweist.

15. Wafer-Chuck nach einem der vorhergehenden Ansprüche, bei dem die elektrisch leitfähige Beschichtung (8) eine Gesamtdicke von weniger als 300 nm und die reflektierende Beschichtung (10) eine Gesamtdicke von weniger als 400 nm aufweist.

16. Wafer-Chuck nach einem der vorhergehenden Ansprüche, bei dem die zweite Schicht (7; 12) ausgebildet ist, eine durch Wasserverlust in einer Vakuum-Umgebung (9) hervorgerufene Spannungsänderung der ersten Schicht (3; 11) zu kompensieren.

## Claims

1. Wafer chuck (1a, 1b) having a substrate (2) and having, applied to the substrate (2), an electrically conductive coating (8) for fixing a wafer (6) by electrostatic attraction and preferably having a reflective coating (10) applied to the substrate (2),
**characterised in that**
the coating (8; 10) has at least a first layer (3; 11) under compressive stress, and at least a second layer (7; 12) under tensile stress for compensating for the compressive stress of the first layer (3; 11).

2. Wafer chuck according to claim 1, wherein the material of the first layer (3) of the electrically conductive coating (8) is selected from the group comprising: nitrides, carbides and silicides.

3. Wafer chuck according to claim 1 or 2, wherein the material of the first layer (3) of the electrically conductive coating (8) is selected from the group comprising: titanium nitride (TiN), chromium nitride (CrN), molybdenum silicide (MoSi₂), silicon carbide (SiC) and silicon nitride (Si₃N₄).

4. Wafer chuck according to any one of the preceding claims, wherein the second layer (7) of the electrically conductive coating (8) has a tensile stress of from 100 MPa to 1600 MPa, preferably from 800 MPa to 1300 MPa.

5. Wafer chuck according to any one of the preceding claims, wherein the second layer (7) of the electrically conductive coating (8) is composed of a metal, preferably of chromium.

6. Wafer chuck according to any one of the preceding claims, wherein the second layer (7) of the electrically conductive coating (8) is formed from a material having a higher electrical conductivity than the material of the first layer (3).

7. Wafer chuck according to any one of the preceding claims, wherein the first layer (3) of the electrically conductive coating (8) has a thickness of less than 200 nm, preferably less than 100 nm, especially less than 50 nm.

8. Wafer chuck according to any one of the preceding claims, wherein the substrate (2) is composed of a non-conductive material, especially Zerodur.

9. Wafer chuck according to any one of the preceding claims, wherein the first layer (3; 11) is applied to the second layer (7; 12).

10. Wafer chuck according to any one of the preceding claims, wherein the first layer (3) of the electrically conductive coating (8) is formed by sputtering, especially with ion assistance, and the second layer (7) is formed by thermal evaporation.

11. Wafer chuck according to any one of the preceding claims, wherein the coating (8; 10) is formed from metallic layer materials and/or from dielectric layer materials deposited with ion assistance.

12. Wafer chuck according to any one of the preceding claims, wherein the reflective coating (10) has at least one metallic layer material, especially aluminium (Al) or silver (Ag).

13. Wafer chuck according to any one of the preceding claims, wherein the reflective coating (10) has at least one layer material deposited preferably with ion assistance which is selected from the group comprising: titanium dioxide (TiO₂), silicon dioxide (SiO₂), hafnium dioxide (HfO₂) and zirconium dioxide (ZrO₂).

14. Wafer chuck according to any one of the preceding claims, wherein the coating (8; 10) has a water-impermeable sealing layer (13).

15. Wafer chuck according to any one of the preceding claims, wherein the electrically conductive coating (8) has a total thickness of less than 300 nm and the reflective coating (10) has a total thickness of less than 400 nm.

16. Wafer chuck according to any one of the preceding claims, wherein the second layer (7; 12) is in a form such as to compensate for a change in stress in the first layer (3; 11) caused by the loss of water in a vacuum environment (9).

## Revendications

1. Support individuel de tranche (1a, 1b), avec un substrat (2) et avec un revêtement électro-conducteur (8) appliqué sur le substrat (2) pour la fixation d'une tranche (6) par attraction électrostatique, et de préférence avec un revêtement réfléchissant (10) appliqué sur le substrat (2),
**caractérisé en ce que** le revêtement (8 ; 10) présente au moins une première couche (3 ; 11) soumise à une contrainte de compression et au moins une deuxième couche (7 ; 12) soumise à une contrainte de traction, pour compenser la contrainte de compression de la première couche (3 ; 11).

2. Support individuel de tranche selon la revendication 1, dans lequel le matériau de la première couche (3) du revêtement électro-conducteur (8) est choisi dans le groupe comprenant les nitrures, les carbures et les siliciures.

3. Support individuel de tranche selon la revendication 1 ou 2, dans lequel le matériau de la première couche (3) du revêtement électro-conducteur (8) est choisi dans le groupe comprenant le nitrure de titane (TiN), le nitrure de chrome (CrN), le siliciure de molybdène (MoSi₂), le carbure de silicium (SiC) et le nitrure de silicium (Si₃N₄).

4. Support individuel de tranche selon l'une des revendications précédentes, dans lequel la deuxième couche (7) du revêtement électro-conducteur (8) présente une contrainte de traction comprise entre 100 MPa et 1600 MPa, de préférence entre 800 MPa et 1300 MPa.

5. Support individuel de tranche selon l'une des revendications précédentes, dans lequel la deuxième couche (7) du revêtement électro-conducteur (8) est constituée d'un métal, de préférence de chrome.

6. Support individuel de tranche selon l'une des revendications précédentes, dans lequel la deuxième couche (7) du revêtement électro-conducteur (8) est formée d'un matériau ayant une plus grande conductivité que le matériau de la première couche (3).

7. Support individuel de tranche selon l'une des revendications précédentes, dans lequel la première couche (3) du revêtement électro-conducteur (8) présente une épaisseur inférieure à 200 nm, de préférence inférieure à 100 nm, en particulier inférieure à 50 nm.

8. Support individuel de tranche selon l'une des revendications précédentes, dans lequel le substrat (2) est constitué d'un matériau non conducteur, en particulier de Zerodur.

9. Support individuel de tranche selon l'une des revendications précédentes, dans lequel la première couche (3 ; 11) est appliquée sur la deuxième couche (7 ; 12).

10. Support individuel de tranche selon l'une des revendications précédentes, dans lequel la première couche (3) du revêtement électro-conducteur (8) est formée par pulvérisation, en particulier avec l'aide d'ions, et la deuxième couche (7) par vaporisation thermique.

11. Support individuel de tranche selon l'une des revendications précédentes, dans lequel le revêtement (8 ; 10) est formé de matériaux métalliques en couches et/ou de matériaux diélectriques en couches, déposés avec l'aide d'ions.

12. Support individuel de tranche selon l'une des revendications précédentes, dans lequel le revêtement réfléchissant (10) présente au moins un matériau métallique en couche, en particulier de l'aluminium (Al) ou de l'argent (Ag).

13. Support individuel de tranche selon l'une des revendications précédentes, dans lequel le revêtement réfléchissant (10) présente au moins un matériau en couche, déposé de préférence avec l'aide d'ions, qui est choisi dans le groupe comprenant le dioxyde de titane (TiO₂), le dioxyde de silicium (SiO₂), le dioxyde d'hafnium (HfO₂) et le dioxyde de zirconium (ZrO₂).

14. Support individuel de tranche selon l'une des revendications précédentes, dans lequel le revêtement (8 ; 10) présente une couche de scellement (13) imperméable à l'eau.

15. Support individuel de tranche selon l'une des revendications précédentes, dans lequel le revêtement électro-conducteur (8) présente une épaisseur totale inférieure à 300 nm et le revêtement réfléchissant (10) une épaisseur totale inférieure à 400 nm.

16. Support individuel de tranche selon l'une des revendications précédentes, dans lequel la deuxième couche (7 ; 12) est formée pour compenser une modification de la contrainte de la première couche (3 ; 11) qui est produite par la perte d'eau dans un environnement sous vide (9).
